# EUROPEAN PATENT SPECIFICATION

(11) **EP 2 761 054 B1**
(45) Date of publication and mention of the grant of the patent: **14.08.2019**
(21) Application number: 12836663.0
(22) Date of filing: 13.09.2012
(51) Int. Cl.: C23C 16/40, C23C 16/453, C07F 7/08, C07F 7/12, C07F 7/18, G02B 1/10, C03C 17/245

(54) **DEPOSITION OF SILICON OXIDE BY ATMOSPHERIC PRESSURE CHEMICAL VAPOR DEPOSITION**
SILICIUMOXIDBESCHICHTUNG DURCH EINE CHEMISCHE DAMPFABLAGERUNG UNTER NORMALDRUCK
DÉPÔT D'OXYDE DE SILICIUM PAR DÉPOSITION CHIMIQUE EN PHASE VAPEUR À PRESSION ATMOSPHÉRIQUE

(30) Priority: 30.09.2011 US 201161541311 P
(43) Date of publication of application: 06.08.2014
(73) Proprietor: Arkema, Inc., King of Prussia, PA 19406 (US)
(72) Inventor: SMITH, Ryan C., Schwenksville, Pennsylvania 19473 (US); STRICKER, Jeffery L., Narberth, Pennsylvania 19072 (US)
(74) Representative: Schaefer, Anne-Sophie
(86) International application number: PCT/US2012/055043
(87) International publication number: WO 2013/048751

(56) References cited:
- EP-A2- 1 039 520
- EP-A2- 1 143 499
- US-A- 4 981 724
- US-A- 4 981 724
- US-A- 5 527 629
- US-A- 5 670 224
- US-B2- 6 716 770

## Description

### FIELD OF THE INVENTION

The invention relates to chemical vapor deposition processes for depositing silicon oxide films on substrates.

### BACKGROUND OF THE INVENTION

Chemical vapor deposition (CVD) is a chemical process used to produce high-purity, high-performance solid materials and is often used in the semiconductor industry to produce thin films. In a typical CVD process, a substrate is exposed to one or more volatile precursors, which react and/or decompose on the substrate surface to produce the desired deposit or film. The deposit or film may contain one or more types of metal atoms, which may be in the form of metals, metal oxides, metal nitrides or the like following reaction and/or decomposition of the precursors. EP1 143 499 discloses a CVD method for depositing a SiOx layer on a substrate using an alkoxylsilane such as monoethylsilane with an oxidizer.

For example, a CVD process may be used to apply various coatings or films onto transparent substrates such as, e.g., soda-lime glass, in order to reflect long-wavelength infrared radiation. Depending on the substrate and functional coating refractive indices, various reflected iridescent (visible) colors may be observed. This iridescent effect is considered to be detrimental to the appearance of the glass in applications such as windows with low emissivity or bottles for food or beverages, for example. Therefore, an anti-iridescent coating may be applied onto a transparent substrate in order to reduce the observation of visible color.

Suitable anti-iridescent coatings may include, for example, silicon oxide. A common precursor used commercially to apply silicon oxide coatings by atmospheric pressure chemical vapor deposition (APCVD) is tetraethoxysilane (TEOS). TEOS often requires the use of a promoter or accelerant, such as a phosphite, however, to achieve suitable deposition rates. In addition, deposition efficiency is often quite low, which can lead to fouling of the coating equipment causing non-uniformities in the deposited film as well as frequent cleaning of the equipment. Alternatively, silane (SiH₄) may be used instead of TEOS, but silane is pyrophoric and requires special handling to limit its exposure to air and moisture making its use more common in low
pressure applications. Thus, there is a need for a precursor for silicon oxide that provides film deposition rates under atmospheric conditions that are significantly faster and more efficient than TEOS, but without the handling issues of silane.

### SUMMARY OF THE INVENTION

Aspects of the present invention include methods for producing silicon oxide-containing layers on substrates, such as glass, at faster deposition rates and higher deposition efficiencies and the products obtainable therefrom.According to an embodiment of the present invention, it is provided a method of forming at least one silicon oxide-containing layer on a substrate comprising (a) heating a substrate (b) vaporizing at least one precursor comprising a monoalkylsilane selected from the group consisting of n-butylsilane, n-hexylsilane, n-octylsilane, and mixtures thereof to form a vaporized precursor stream; and (c) contacting a surface of the heated substrate with the vaporized precursor stream at about atmospheric pressure, in presence of an oxidant, to deposit at least one layer comprising silicon oxide onto the surface of the substrate.It is also disclosed a silicon oxide-containing thin film is obtained by using an atmospheric pressure chemical vapor deposition process. A substrate is heated, and then a surface of the heated substrate is contacted with a precursor gas comprising vaporized monoalkylsilane having an alkyl group with greater than two carbon atoms at about atmospheric pressure to produce the silicon oxide-containing film.

It is also disclosed a method of producing at least one anti-iridescent silicon oxide coating on a glass substrate includes heating a glass substrate and vaporizing at least one precursor comprising a monoalkylsilane having an alkyl group with greater than two carbon atoms to form a vaporized precursor stream. A surface of the heated glass substrate is then contacted with the vaporized precursor stream and an oxidant at about atmospheric pressure to deposit at least one layer comprising silicon oxide having a refractive index ranging from about 1.4 to about 2.0 onto the surface of the glass substrate.

### DETAILED DESCRIPTION OF THE INVENTION

Aspects of the present invention include methods of forming at least one silicon oxide layer on a substrate and the products obtained therefrom. In particular, embodiments of the present invention provide a process for depositing silicon oxide films on glass substrates, such as during production of glass in an online float glass process.

According to one aspect of the present invention, the method includes forming at least one silicon oxide-containing layer (e.g., a thin film, skin, covering, or coating may be used interchangeably and are terms well known to those of ordinary skill in the art) on a substrate. As used herein, the term "silicon oxide" is meant to include all silicon oxides of varying atomic ratios, such as a silicon dioxide (most common) and silicon monoxide. Silicon dioxide or silica is an oxide of silicon with the chemical formula SiO₂. The thicknesses of the layers or films are not especially limited and may be any suitable thickness useful to one of ordinary skill in the art. For example, the films may range from about 1 nm to 1500 µm in thickness, such as about 20 to 500 nm in thickness, more particularly about 20 to 100 nm in thickness.

In another embodiment, the silicon oxide-containing layer comprises, for example, silicon oxide (e.g., silicon dioxide) in substantially pure form or as a mixed oxide. As used herein, "substantially pure" is intended to encompass a layer consisting essentially of silicon oxide, such as a silicon oxide layer having greater than 90%, greater than 95%, or greater than 99% or greater purity, (e.g., a layer of silicon oxide along with some common impurities, such as residual carbon, etc.) or consisting of only silicon oxide. The "mixed oxide" may include silicon oxide along with at least one additional metal, transitional metal, or oxide thereof. In an exemplary embodiment, the mixed oxide may include silicon oxide and at least one metal or transition metal oxide, such as tin oxide, titanium oxide, aluminum oxide, zinc oxide, indium oxide, etc. The mixed oxide may be a composite oxide, homogenous oxide, heterogeneous oxide, or the like. Additionally, the oxides may be doped or undoped metal oxides.

Due to its relatively low refractive index, silicon oxide is a suitable component of an anti-iridescent coating, either as a discreet layer or as a constituent of a mixture
with a material having a higher refractive index. As previously noted, various reflected iridescent (visible) colors may be observed when coatings are applied to certain transparent substrates, such as float glass (refractive index of about 1.52). This iridescent effect can be detrimental to the appearance of the glass depending on the application. Accordingly, an anti-iridescent coating (or coating stack) containing silicon oxide may be applied to the glass in order to reduce the observation of visible color. A coating containing substantially pure silicon oxide may have a refractive index of about 1.46. A coating containing a mixed oxide of silicon oxide along with a higher refractive index material, such as tin oxide (refractive index of about 1.9-2.0) may also be used. The ratio of the mixed oxide may be selected such that the layer has a refractive index ranging from about 1.4 to about 2.0. Additionally, depending on the application, it may be desirable to provide a coating or coatings that are substantially or completely transparent. By "substantially transparent" it is meant that the coating does not substantially affect the visible transmittance of the substrate. For example, the visible transmittance of the coated substrate is at least equal to 50%, 80%, 90%, or 95% of the visible transmittance of the uncoated substrate.

As used herein and in the claims, the terms "comprising" and "including" are inclusive or open-ended and do not exclude additional unrecited elements, compositional components, or method steps. Accordingly, the terms "comprising" and "including" encompass the more restrictive terms "consisting essentially of" and "consisting of." Unless specified otherwise, all values provided herein include up to and including the endpoints given.

According to one embodiment of the present invention, a method of forming at least one silicon oxide-containing layer on a substrate comprising (a) heating a substrate (b) vaporizing at least one precursor comprising a monoalkylsilane selected from the group consisting of n-butylsilane, n-hexylsilane, n-octylsilane, and mixtures thereof to form a vaporized precursor stream; and (c) contacting a surface of the heated substrate with the vaporized precursor stream at about atmospheric pressure, in presence of an oxidant, to deposit at least one layer comprising silicon oxide onto the surface of the substrate.

The method includes forming a silicon oxide-containing layer on a substrate. The substrates suitable for use in the present invention may include any substrate capable of having a layer deposited thereon, for example, in a chemical vapor deposition process. Glass substrates, including glass substrates already coated with one or more coatings, are especially suitable. Polymer substrates may also be suitable depending on the application. In one embodiment, the substrate is transparent (e.g., greater than 80% transmission, greater than 90% transmission, etc.). In particular, the substrate may be formed of any suitable transparent material for transmitting light at a desired wavelength range.

Illustrative examples of suitable glass substrate materials include, but are not limited to, soda lime silica glass including soda lime float glass and low-iron soda lime glass; silica glass including borosilicate glass, aluminosilicate glass, phosphosilicate glass, and fused silica glass; lead glass; flat panel glass; and the like.

Illustrative examples of suitable polymer substrate materials include, but are not limited to, polymeric substrates such as fluoropolymer resins, polyacrylates (e.g., polymethylmethacrylate), polyesters (e.g., polyethylene terephthalate), polyamides, polyimides, polycarbonates and the like. For example, a polymer substrate may be selected from the group consisting of polyvinylidene fluoride (PVDF), polyethylene terephthalate (PET), polyethylene naphthalate (PEN), polymethyl methacrylate (PMMA), and combinations thereof.

In one embodiment, the substrate is selected from glass, fluoropolymer resins, polyacrylates, polyesters, polyamides, polyimides, or polycarbonates. In other embodiments the substrate is glass. In yet another embodiment, the substrate is substantially or completely transparent.

Other components may also be compounded together with the glass or polymer substrate. For example, fillers, stabilizers, light diffusers, colorants, etc. may be added to and incorporated with the substrate or applied to the surface of the substrate based on the properties desired.

The substrate may be in any suitable form. For instance, the substrate may be a sheet, a film, a composite, or the like. The substrate may also be of any suitable thickness based on the intended application. For example, the thickness may range from about 0.55 mm to 19 mm.

According to one embodiment of the present invention, a method of forming at least one silicon oxide-containing layer on a substrate includes heating the substrate. The substrate may be heated at any suitable point during the process. For example, the substrate may be heated before or after it is contacted with the vaporized precursor stream. In one embodiment, the substrate is heated first. Additionally, the substrate may be heated during the process, or the substrate may already be of a certain temperature during formation.

For example, in a float glass process (e.g., the Pilkington process) a sheet of glass is made by floating molten glass on a bed of molten metal, such as tin (e.g., a tin bath). The glass flows onto the tin surface forming a floating ribbon. As the temperature is reduced, the ribbon can be removed from the bath to form a glass sheet. Other process steps may also be used in the float glass process as would be known to one of ordinary skill in the art. Accordingly, the substrate may already be heated during any suitable step of this float glass process (or cooled from a higher temperature during formation, yet is still heated for purposes of the present invention) and may be simultaneously used in the deposition process according to the invention. In one embodiment, the substrate is heated to temperatures typically encountered in or compatible with a float glass operation. For example, the substrate may be heated to a temperature ranging from about 300°C to about 800°C, from about 400°C to about 800°C, from about 500°C to about 700°C, or from about 600°C to about 650°C.

According to one embodiment of the present invention, a method of forming at least one silicon oxide-containing layer on a substrate includes vaporizing at least one precursor that includes a monoalkylsilane having an alkyl group with greater than two carbon atoms to form a vaporized precursor stream.

The monoalkylsilane having an alkyl group with greater than two carbon atoms in some embodiments is represented by the formula RSiH₃ where R is an alkyl group having the formula CₙH₂ₙ₊₁ where n is greater than 2. The monoalkylsilane is preferably a long chain monoalkylsilane (e.g., the alkyl group has greater than two carbon atoms, more particularly four or more carbon atoms) as opposed to a short chain monoalkylsilane (e.g., one or two carbon atoms, monomethylsilane and monoethylsilane, respectively). Contrary to what a skilled artisan might expect, monomethylsilane and monoethylsilane are not suitable in the present invention even though they can decompose quickly and easily to form silicon oxides. In an exemplary application of the present invention, the precursor is deposited on glass during a float glass process (e.g., a continuous moving web), which is under atmospheric conditions. Short chain monoalkylsilanes are pyrophoric and therefore react readily with air or water. Accordingly, there are safety issues and concerns about leaks of short chain monoalkylsilanes in an open air and/or atmospheric environment. In contrast, a vacuum or low pressure CVD process may not have the same concerns with short chain monoalkylsilanes because the reactions can be controlled during this low pressure batch processing.

Accordingly, suitable precursors include a monoalkylsilane, RSiH₃, having an alkyl group R with greater than two carbon atoms or greater than three carbon atoms. The R alkyl group may be linear, branched, or cyclic and saturated or unsaturated. In one embodiment, the monoalkylsilane is a liquid at room temperature and atmospheric pressure and is air stable. It may be preferred that the monoalkylsilane is easily vaporizable (e.g., having a suitably high vapor pressure). For example, the R alkyl group may contain 3 to 20 carbon atoms, more particularly, 4 to 12 carbon atoms, and even more particularly 4 to 8 carbon atoms. The monoalkylsilane may also include all of its different isomers and stereoisomers, including all single configurational isomers, single stereoisomers, and any combination thereof in any ratio. In an exemplary embodiment, the monoalkylsilane is selected from of n-butylsilane, n-hexylsilane, n-octylsilane, or mixtures thereof. In another embodiment, the monoalkylsilane has the chemical formula H₃C(CH₂)ₙSiH₃ where n is 3 to 7.

As shown above, the monoalkylsilane does not contain any other functional groups attached to the Si atom (such as additional alkyl groups, oxy groups, halogens, etc.). That is, the Si atom in the monoalkylsilane is substituted with three hydrogen atoms and one alkyl group. It was discovered that additional functional groups directly attached to the Si atom may lead to poor or no deposition on the substrate. Accordingly, the monoalkylsilane is not a dialkylsilane, an alkoxysilane, nor a halogenated alkylsilane (e.g., fluorinated, chlorinated, etc.).

The precursor may comprise one or more types of precursors. The precursor may include one or more monoalkylsilanes and optionally, one or more additional precursors including any suitable precursor known to one skilled in the art. It is desirable that the silicon oxide precursor is compatible for gas-phase mixing with precursors of higher refractive index oxides, such as tin oxide, as well as with air and/or water. Additionally, precursors for use in co-deposition processes, where more than one metal is deposited, are preferred to have minimal or no detrimental effect on the coherent deposition of layers when used in the presence of other precursors.

In one embodiment, the additional precursors contain metal or transition metal compounds that can readily form into their respective oxides. For example, suitable precursors may be selected to form high refractive index oxides (e.g., having a refractive index greater than 1.5), such as tin oxides, titanium oxides, aluminum oxides, zinc oxides, zirconium oxides, indium oxides, or mixtures thereof. In an exemplary embodiment, the monoalkylsilane precursor is mixed with a tin oxide precursor, such as monobutyltin trichloride, to form a film of mixed silicon and tin oxide. Other suitable tin precursors may include tin tetrachloride and dimethyltin dichloride, for example.

The precursor(s) may be vaporized to form a vaporized precursor stream and introduced in a gaseous phase (i.e., vapor form). In an exemplary embodiment, the precursors, for example, obtained in a liquid form, are first vaporized using suitable equipment and techniques and contacted with a substrate. One skilled in the art will appreciate that it is also possible to apply the precursor as a liquid using techniques such as spray pyrolysis. In this embodiment, the liquid is sprayed and vaporized *in situ* when it is in close proximity to the heated substrate. A liquid application may cause adverse effects on the resulting silicon oxide composition (e.g., introduce more impurities) and may limit the deposition operation (e.g., thickness restrictions, deposition rates/efficiency, and film uniformity) especially in the float glass process.

One or more additional components may also be introduced into the vaporized precursor stream or contacted with the substrate when the precursor vapor is contacted with the substrate. These additional components may be admixed with the precursors before, or may be simultaneously contacted with the precursor vapor and the substrate. For example, such admixing may take place at the same time the precursor vapor is contacted with the substrate (for example, a first stream comprising a first precursor vapor and a second stream comprising a second precursor vapor may be directed towards the substrate) or in advance of contacting the precursor vapor with the substrate (for example, a first stream comprising a first precursor vapor and a second stream comprising a second precursor vapor may be admixed to form the vaporized precursor stream comprised of multiple precursor vapors, which is then directed towards the substrate).

Such additional components or precursors may include, for example, oxygen-containing compounds, particularly compounds that do not contain a metal, such as esters, ketones, alcohols, hydrogen peroxide, oxygen (O₂), air, or water (including water vapor), which may be capable of acting as oxidants. The precursor vapor may be admixed with an inert carrier gas such as nitrogen, helium, argon, or the like. In an exemplary embodiment, the vaporized precursor stream further includes at least one of dry air, oxygen, nitrogen, or water vapor or mixtures thereof.

In an exemplary embodiment, streams containing a) a carrier gas having the vaporized monoalkylsilane precursor, and b) one or more gaseous streams containing one or more of dry air, oxygen, nitrogen, water vapor, and one or more of vaporized precursors of high refractive index oxides (such as tin oxide, titanium oxide, aluminum oxide, zinc oxide, etc.) may be combined to form a single precursor stream, which is applied to the heated substrate. Examples of suitable precursors for forming these metal oxides are disclosed in for example US Patent Nos. 4,377,613, US 4,187,336, and 5,401,305, the disclosures of which are each hereby incorporated by reference in their entirety.

It is noted, for completeness, that an oxidant would be present with the monoalkylsilane precursor to produce the silicon oxide coating. In one embodiment, the monoalkylsilane precursor is applied in an open air environment or an environment where oxygen is readily present, which would act as an oxidant. In another embodiment, dry air is also introduced as an additional oxidant with the vaporized precursor stream. In yet another embodiment, dry air and/or water vapor may be introduced to oxidize and accelerate the reaction.

In an exemplary embodiment, the vaporized precursor stream or any other stream contacted with the substrate does not include a promoter or accelerant (e.g., a chemical promoter, complex compound, salt, etc.). In comparison to tetraethoxysilane (TEOS), it was discovered that the monoalkylsilanes according to the present invention do not require an accelerant, such as phosphites (e.g., triethylphosphite), which are used with TEOS to achieve suitable deposition rates. Additionally, deposition efficiency is improved by using monoalkylsilanes according to the present invention even without the use of an accelerant, which may minimize the rate of fouling of the coating equipment and reduce issues associated with the fouling (e.g., minimizing non-uniformities in the deposited film and reducing the amount of cleaning of the equipment). Additionally, a promoter, such as ozone, is not required to achieve good deposition rates and efficiency (for example, the vaporized stream may not be enriched with ozone).

A surface of the heated substrate is contacted with the vaporized precursor stream at about atmospheric pressure to deposit a layer comprising silicon oxide onto the surface of the substrate (e.g., atmospheric pressure chemical vapor deposition (APCVD)). The substrate is contacted with the vaporized precursor(s) at about atmospheric pressure or standard atmosphere (e.g., about 101.325 kPa or about 760 mmHg (torr)).

A low pressure or vacuum CVD process is typically not desired and may provide a negative impact on the silicon oxide deposition process. In particular, a low pressure environment could result in high residual carbon in the deposited film, which would require either means to remove the carbon or the carbon would be incorporated into the layer (e.g., producing silicon carbide). In contrast, the atmospheric pressure environment according to the present invention allows for minimal or negligible residual carbon.

The CVD process according to the invention is also not a plasma-assisted chemical vapor deposition process (PACVD). In PACVD, an electric discharge is needed and the precursor is passed through an electric field to enhance deposition rates. The PACVD process may result in uncontrolled deposition, and the precursors selected in the present invention do not require an electric discharge to activate the reaction. In comparison, the APCVD process and the monoalkylsilanes of the invention allow for fast deposition rates (e.g., at rates suitable for use in an online float glass process) in a controlled manner.

The heated substrate is contacted with the vaporized precursor stream to deposit a layer comprising silicon oxide onto the surface of the substrate. As the precursors activate and decompose, they deposit onto the substrate and form the film or layer. The vaporized precursor may be introduced using any suitable equipment and techniques known to one of ordinary skill in the art. For example, the vaporized precursor stream may be introduced via a coating nozzle adjacent to the surface of the heated substrate. The coating nozzle may include, for example, at least one inlet through which the vaporized precursors impinge onto the substrate surface and at least one outlet through which volatile reaction byproducts may be removed from the substrate/film surface.

The substrate and the vapor precursor(s) may be introduced into an open or closed reactor vessel. In one embodiment, the vaporized precursor stream is applied to the substrate in an atmospheric environment. In another embodiment, the precursor stream is applied to a glass substrate after formation in a continuous, online web glass float process. Although the method is particularly suitable for a float glass production line, the coating process described herein may be implemented in any suitable coating environment, such as conveyor furnace systems, and the like.

The processes disclosed herein may be used to produce one or more layers or films deposited on a substrate. Preferably, the incorporation of non-activated precursors (in a partially decomposed state) or other contaminants is minimized or avoided in the layer. Such contaminants may have an adverse impact on the desired refractive index, transparency, or emissivity of the material. For example, it is desired that deposition of silicon carbide (SiC) is avoided or minimized. Silicon carbides are not desirable, especially in glass applications, because they are high refractive index materials that can have significant absorption in the visible range (e.g., the silicon carbides would not work as an effective anti-iridescent coating). For instance, the silicon oxide-containing thin film may comprise less than 10% residual carbon, less than 5% residual carbon, less than 1% residual carbon, or even less than 1000 ppm residual carbon. Accordingly, the silicon oxide-containing film may contain negligible amounts of residual carbon.

The deposition processes may be used to produce a single layer or multiple layers. The layers may be the same or different layers and may be of any suitable thickness. For example, the film may be in the range of about 20 nm to 100 nm in thickness. Additional coatings or layers may also be applied between a silicon oxide layer and the substrate or on top of a silicon oxide layer. Suitable coatings are well known to one skilled in the art, especially anti-iridescent coatings, anti-reflective coatings or other coating stacks for glass applications such as those used in organic light emitting devices (OLEDs) and photovoltaic cells (PVs).

In one embodiment of the present invention, the silicon oxide-containing layer comprises silicon dioxide and small amounts of other silicon oxides in a substantially pure form. For example, a single layer may include only silicon dioxide and other silicon oxides or consist essentially of silicon dioxide (e.g., along with some common impurities, such as residual carbon, etc.). Silicon dioxide, a low refractive index material, may have a refractive index ranging from about 1.45 to 1.50.

Alternatively, a single layer may include a mixed oxide having silicon oxide along with at least one additional metal, transition metal, or oxide thereof. For example, the mixed oxide may include silicon oxide and at least one metal or transition metal oxide, such as tin oxide, titanium oxide, aluminum oxide, zinc oxide, indium oxide, or mixtures thereof. The additional metal or metal oxide may be selected from high refractive index materials (e.g., greater than 1.5). For example, tin oxide may have a refractive index around about 1.9 to 2.0. Accordingly, the silicon oxide and additional metal or metal oxide having a higher refractive index may be mixed together in appropriate proportions such that a desired refractive index can be achieved. For example, the refractive index may be varied depending on the relative delivery rates of the precursors (e.g., monoalkylsilane and tin precursors).

The present invention also provides processes for depositing various layers onto a substrate, such as glass, that will employ the monoalkylsilane precursor in one or more layers. For example, the substrate may have a coating stack that includes a silicon oxide layer sandwiched between a fluorine-doped tin oxide layer and the glass substrate. In such an embodiment, the silicon oxide layer may have a thickness ranging from about 10 to about 100 nm, and the fluorine doped tin oxide layer may have a thickness from about 50 to about 1000 nm. Such stacked coatings are useful in applications such as low-emissivity windows, photovoltaics, anti-fog glass, and induction heating.

In other embodiments, the substrate, such as glass, may first be coated with a layer containing tin oxide, followed by a layer containing silicon oxide, followed by a layer containing fluorine doped tin oxide. In such an embodiment, the tin oxide layer may have a thickness ranging from about 10 to about 30 nm, the silicon oxide layer may have a thickness ranging from about 10 to about 40 nm, and the fluorine doped tin oxide layer may have a thickness from about 50 to about 1000 nm. Such stacked coatings are useful in applications such as low-emissivity windows, photovoltaics, anti-fog glass, and induction heating.

In other embodiments, the substrate, such as glass, may first be coated with a mixed oxide layer containing tin oxide and silicon oxide, followed by a layer containing fluorine doped tin oxide. In such an embodiment, the ratio of silicon oxide and tin oxide in the mixed oxide layer may be adjusted to provide a desired refractive index. For example the ratio may be adjusted to provide a refractive index ranging from about 1.55 to about 1.85. In such embodiments the mixed oxide layer may have a thickness ranging from about 20 to about 150 nm, and the fluorine doped tin oxide layer may have a thickness ranging from about 50 to about 1000 nm. Such stacked coatings are useful in applications such as low-emissivity windows, photovoltaics, anti-fog glass, and induction heating.

In another embodiment of the invention, a method of producing an anti-iridescent silicon oxide coating on a glass substrate includes:
(a) heating a glass substrate;
(b) vaporizing at least one precursor comprising a monoalkylsilane having an alkyl group with greater than two carbon atoms to form a vaporized precursor stream; and
(c) contacting a surface of the heated glass substrate with the vaporized precursor stream and an oxidant at about atmospheric pressure to deposit at least one layer comprising silicon oxide having a refractive index ranging from about 1.4 to about 2.0 onto the surface of the glass substrate.

The conditions and reactants described herein for the present invention provide for fast, controlled deposition rates and higher deposition efficiency. For example, the monoalkylsilane precursors can be vaporized, mixed with dry air and water vapor, and delivered via a single gas stream to a heated substrate to form deposited films of silicon oxide at deposition rates substantially higher than those achieved using TEOS. In particular, the layer comprising silicon oxide may be deposited onto the surface of the substrate at a rate greater than 3 nm/second, at a rate greater than 4 nm/second, or even at a rate greater than 5 nm/second, for example. In one embodiment, the layer comprising silicon oxide may be deposited onto the surface of the substrate at a rate ranging from about 5 nm/second to about 25 nm/second or even higher. Moreover, the films can be deposited in a controlled manner such that fouling is reduced or minimized leading to less impurities in the films and less downtime for cleaning and maintenance of the equipment.

Based on the foregoing, a silicon oxide-containing thin film may be obtained by using an atmospheric pressure chemical vapor deposition process including:
(a) heating a substrate; and
(b) contacting a surface of the heated substrate with a precursor gas comprising vaporized monoalkylsilane having an alkyl group with greater than two carbon atoms at about atmospheric pressure to produce the silicon oxide-containing film.

Using embodiments of the present invention, it is possible to obtain coatings that are anti-iridescent, anti-reflective, and transparent to visible light (e.g., high visible light transmittance). Additionally, it is envisioned that the layer exhibits good durability, for example, by demonstrating good adhesion to the substrate (e.g., the coating will not delaminate over time).

Possible applications of the coatings or films made in accordance with the present invention include, but are not limited to, anti-reflection coatings, anti-iridescent coatings, barrier coatings, and the like. In particular, the coatings described herein may be used as a vital component of the pyrolytic coatings (such as low emissivity, transparent conductive oxides (TCOs), etc.) on glass as an anti-iridescent first coating (or coating stack) to reduce the observation of visible color of the coating stack.

### EXAMPLES

The invention is further illustrated by reference to the following examples.

### Example 1: SiO₂ Deposition from n-Octylsilane Precursor + Air

n-Octylsilane was vaporized in 4.5 standard liters per minute (slm) nitrogen carrier gas heated to 180°C. The vaporized n-octylsilane stream was then combined with 6.5 slm dry air heated to 180°C and delivered as a single stream to the surface of a sodalime silica glass substrate. The sodalime silica glass substrate had been precoated with 170 nm of tin oxide and was heated to 625-650°C. Post-deposition optical characterization revealed formation of approximately 390 nm of silicon dioxide at a deposition rate of 6.5 nm/s.

Note: The SiO₂ was deposited onto a tin oxide (high refractive index) coated glass to facilitate the optical characterization of the resultant layer. In practice, the SiO₂ could be deposited directly onto a glass substrate.

### Comparative Example 2: SiO₂ Deposition from TEOS Precursor

For comparison, the same experiment was repeated as provided in Example 1 except a 1:1 molar ratio of TEOS and triethyl phosphite was used instead of n-octylsilane as the vaporized precursor. Post-deposition optical characterization revealed formation of approximately 125 nm silicon dioxide at a deposition rate of 2.1 nm/s.

### Example 3: SiO₂ Deposition from n-Hexylsilane Precursor + Air

The same experiment was repeated as provided in Example 1 using n-hexylsilane as the alkylsilane precursor instead of n-octylsilane. Post-deposition optical characterization revealed formation of approximately 350 nm silicon dioxide at a deposition rate of 6 nm/s.

### Example 4: SiO₂ Deposition from n-Octylsilane Precursor + Air and Water

The same experiment was repeated as provided in Example 1 with n-octylsilane as the vaporized precursor, but water was also added to the precursor mixture. In particular, the conditions of Example 1 were repeated with the addition of approximately 1:1 molar ratio water to silicon precursor. Post-deposition optical characterization showed deposition of approximately 370 nm silicon dioxide at a rate of 6 nm/s.

### Example 5: SiO₂ Deposition from n-Hexylsilane Precursor + Air and Water

The conditions of Example 4 were repeated using n-hexylsilane in place of n-octylsilane. Optical characterization showed deposition of approximately 330 nm silicon dioxide at a rate of 5.6 nm/s.

### Comparative Example 6: SiO₂ Deposition from TEOS Precursor + Air and Water

The conditions of Example 4 were repeated using 1:1 molar ratio TEOS and triethyl phosphite in place of n-octylsilane. Optical characterization showed deposition of approximately 160 nm silicon dioxide at a rate of 2.7 nm/s.

### Example 7: SiO₂ Deposition from n-Octylsilane Precursor with Monobutyltin Trichloride + Air and Water

n-Octylsilane and monobutyltin trichloride (MBTC) were vaporized in 5 slm nitrogen, which was heated to 180°C. This precursor stream was then combined with a stream of 8 slm dry air heated to 180°C into which 0.22 mol% water was vaporized. This single stream was then delivered to the surface of sodalime silica glass heated to 625-650°C to form a deposit of mixed silicon and tin oxide. Optical characterization was performed to determine refractive index and thickness of the deposited films. By varying the relative amounts of the n-octylsilane and MBTC precursors delivered to the vaporizer, the refractive index ranged between 1.60 and 1.82 for film thickness between 85 - 125 nm. Deposition rate was 5.5 - 8.5 nm/s.

### Comparative Example 8: No SiO₂ Deposition from Acetoxytrimethylsilane Precursor

The conditions of Example 1 were repeated using acetoxytrimethylsilane in place of the n-octylsilane. No film deposition was observed.

The conditions of Example 4 were also repeated using acetoxytrimethylsilane in place of the n-octylsilane. No film deposition was observed. In addition, the molar ratio of water to silicon precursor was increased to approximately 2.4:1 and 3.8:1, respectively, without observable film deposition.

### Comparative Example 9: No SiO₂ Deposition from Tetrakis(dimethylsiloxy)silane

The conditions of Example 1 were repeated using tetrakis(dimethylsiloxy)silane in place of the n-octylsilane. No film deposition was observed.

The conditions of Example 4 were repeated using tetrakis(dimethylsiloxy)silane in place of the n-octylsilane. No film deposition was observed. In addtion, the molar ratio of water to silicon precursor was increased to approximately 2.3:1 and 3.7:1, respectively, without observable film deposition.

### Comparative Example 10: No SiO₂ Deposition from Triisopropylsilane

The conditions of Example 1 were repeated using triisopropylsilane in place of the n-octylsilane. No film deposition was observed.

The conditions of Example 4 were repeated using triisopropylsilane in place of the n-octylsilane. No film deposition was observed. In addtion, the molar ratio of water to silicon precursor was increased to approximately 2.3:1 and 3.8:1, respectively, without observable film deposition.

### Comparative Example 11: No SiO₂ Deposition from n-Butyltrichlorosilane

The conditions of Example 1 were repeated using n-butyltrichlorosilane in place of the n-octylsilane. No film deposition was observed.

The conditions of Example 4 were repeated using n-butyltrichlorosilane in place of the n-octylsilane. No film deposition was observed. In addtion, the molar ratio of water to silicon precursor was increased to approximately 2.3:1 and 3.7:1, respectively, without observable film deposition.

### Comparative Example 12: Negligible SiO₂ Deposition from Allyltrimethoxysilane

The conditions of Example 1 were repeated using allytrimethoxysilane in place of the n-octylsilane. No film deposition was observed.

The conditions of Example 4 were repeated using allytrimethoxysilane in place of the n-octylsilane. Faint film deposition was observed. Following deposition optical characterization revealed formation of approximately 15 nm silicon dioxide at a deposition rate of 0.2 nm/s.

### Comparative Example 13: Negligible SiO₂ Deposition from Triethoxyfluorosilane

The conditions of Example 1 were repeated using triethoxyfluorosilane in place of the n-octylsilane. No film deposition was observed.

The conditions of Example 4 were repeated using triethoxyfluorosilane in place of the n-octylsilane. Faint film deposition was observed. Following deposition optical characterization revealed formation of approximately 12 nm silicon dioxide at a deposition rate of 0.2 nm/s.

### Example 14: SiO₂ Deposition from n-Octylsilane + TEOS + air

The experiment of Example 1 was repeated using a 5:1 volumetric blend of n-octylsilane and TEOS as precursor. Post-deposition optical characterization revealed formation of approximately 60 nm of silicon dioxide at a deposition rate of 1.0 nm/s.

### Example 15: SiO₂ Deposition from n-Octylsilane + TEOS + air + H2O

The experiment above was repeated but water was also added to the precursor mixture. In particular, water was added such that the molar ratio of vaporized water to silicon precursor in the mixture was approximately 1:1. Post-deposition optical characterization showed deposition of approximately 265 nm silicon dioxided at a deposition rate of 4.4 nm/s.

### Example 16: SiO₂ Deposition from n-Octylsilane + TEOS + air + H2O

The experiment above was repeated but a 1:1 volumetric blend of n-octylsilane and TEOS was used in place of the 5:1 volumetric blend. Post-deposition optical characterization showed deposition of approximately 18 nm silicon dioxided at a deposition rate of 0.3 nm/s.

The following table summarizes the above results of deposition of silicon oxide.

| Example | Silane Precursor | Silicon Dioxide Thickness | Deposition Rate |
|---|---|---|---|
| Example 1 | n-octylsilane | 390 nm | 6.5 nm/s |
| Comp. Example 2 | TEOS | 125 nm | 2.1 nm/s |
| Example 3 | n-hexylsilane | 350 nm | 6 nm/s |
| Example 4 | n-octylsilane (plus water) | 370 nm | 6 nm/s |
| Example 5 | n-hexylsilane (plus water) | 330 nm | 5.6 nm/s |
| Comp. Example 6 | TEOS (plus water) | 160 nm | 2.7 nm/s |
| Example 7 | n-octylsilane (plus monobutyltin trichloride) | 85-125 nm | 5.5-8.5 nm/s |
| Comp. Example 8 | acetoxytrimethylsilane | no deposition | n/a |
| Comp. Example 9 | tetrakis(dimethylsiloxy)silane | no deposition | n/a |
| Comp. Example 10 | triisopropylsilane | no deposition | n/a |
| Comp. Example 11 | n-butyltrichlorosilane | no deposition | n/a |
| Comp. Example 12 | allytrimethoxysilane | 15 nm | 0.2 nm/s |
| Comp. Example 13 | triethoxyfluorosilane | 12 nm | 0.2 nm/s |

While preferred embodiments of the invention have been shown and described herein, it will be understood that such embodiments are provided by way of example only.

## Claims

1. A method of forming at least one silicon oxide-containing layer on a substrate comprising:
(a) heating a substrate;
(b) vaporizing at least one precursor comprising a monoalkylsilane selected from the group consisting of n-butylsilane, n-hexylsilane, n-octylsilane, and mixtures thereof to form a vaporized precursor stream; and
(c) contacting a surface of the heated substrate with the vaporized precursor stream at about atmospheric pressure, in presence of an oxidant, to deposit at least one layer comprising silicon oxide onto the surface of the substrate.

2. A method of forming at least one silicon oxide-containing layer on a substrate according to claim 1, wherein the at least one layer comprising silicon oxide has a refractive index ranging from about 1.4 to about 2.0.

3. A method of forming at least one silicon oxide-containing layer on a substrate according to claim 1, wherein the at least one layer comprising silicon oxide is substantially transparent.

4. A method of forming at least one silicon oxide-containing layer on a substrate according to claim 1, wherein the alkyl group of the monoalkylsilane contains at least four carbon atoms.

5. A method of forming at least one silicon oxide-containing layer on a substrate according to claim 1, wherein the substrate is selected from the group consisting of glass, fluoropolymer resins, polyesters, polyacrylates, polyamides, polyimides, and polycarbonates.

6. A method of forming at least one silicon oxide-containing layer on a substrate according to claim 1, wherein at least one layer deposited onto the surface of the substrate is a substantially pure silicon oxide.

7. A method of forming at least one silicon oxide-containing layer on a substrate according to claim 1, wherein at least one layer deposited onto the surface of the substrate is a mixed oxide comprising silicon oxide.

8. A method of forming at least one silicon oxide-containing layer on a substrate according to claim 7, wherein the mixed oxide comprises a high refractive index oxide selected from the group consisting of tin oxides, titanium oxides, aluminum oxides, zinc oxides, indium oxides, and mixtures thereof.

9. A method of forming at least one silicon oxide-containing layer on a substrate according to claim 1, wherein the vaporized precursor stream further comprises at least one of dry air, oxygen, nitrogen, and water vapor.

10. A method of forming at least one silicon oxide-containing layer on a substrate according to claim 1, wherein the vaporized precursor stream does not include a promoter.

11. A method of forming at least one silicon oxide-containing layer on a substrate according to claim 1, wherein the monoalkylsilane is not halogenated.

12. A method of forming at least one silicon oxide-containing layer on a substrate according to claim 1, wherein the substrate is heated to a temperature ranging from about 400°C to about 800°C.

13. A method of forming at least one silicon oxide-containing layer on a substrate according to claim 1, wherein the at least one layer comprising silicon oxide is deposited onto the surface of the substrate at a rate greater than about 3 nm/second.

14. A method of forming at least one silicon oxide-containing layer on a substrate according to claim 1, wherein the layer comprising silicon oxide is deposited onto the surface of the substrate at a rate greater than about 5 nm/second.

## Patentansprüche

1. Verfahren zur Bildung mindestens einer siliciumoxidhaltigen Schicht auf einem Substrat, das Folgendes umfasst:
(a) Erhitzen eines Substrats;
(b) Verdampfen mindestens eines Vorläufers, der ein Monoalkylsilan aus der Gruppe bestehend aus n-Butylsilan, n-Hexylsilan, n-Octylsilan und Mischungen davon umfasst, zur Bildung eines Stroms von verdampftem Vorläufer; und
(c) Inberührungbringen einer Oberfläche des erhitzten Substrats mit dem verdampften Vorläuferstrom bei etwa Atmosphärendruck in Gegenwart eines Oxidationsmittels zur Abscheidung mindestens einer Siliciumoxid umfassenden Schicht auf der Oberfläche des Substrats.

2. Verfahren zur Bildung mindestens einer siliciumoxidhaltigen Schicht auf einem Substrat nach Anspruch 1, bei dem die mindestens eine Siliciumoxid umfassende Schicht einen Brechungsindex im Bereich von etwa 1,4 bis etwa 2,0 aufweist.

3. Verfahren zur Bildung mindestens einer siliciumoxidhaltigen Schicht auf einem Substrat nach Anspruch 1, bei dem die mindestens eine Siliciumoxid umfassende Schicht weitgehend transparent ist.

4. Verfahren zur Bildung mindestens einer siliciumoxidhaltigen Schicht auf einem Substrat nach Anspruch 1, bei dem die Alkylgruppe des Monoalkylsilans mindestens vier Kohlenstoffatome enthält.

5. Verfahren zur Bildung mindestens einer siliciumoxidhaltigen Schicht auf einem Substrat nach Anspruch 1, bei dem das Substrat aus der Gruppe bestehend aus Glas, Fluorpolymerharzen, Polyestern, Polyacrylaten, Polyamiden, Polyimiden und Polycarbonaten ausgewählt wird.

6. Verfahren zur Bildung mindestens einer siliciumoxidhaltigen Schicht auf einem Substrat nach Anspruch 1, bei dem es sich bei mindestens einer auf der Oberfläche des Substrats abgeschiedenen Schicht um ein weitgehend reines Siliciumoxid handelt.

7. Verfahren zur Bildung mindestens einer siliciumoxidhaltigen Schicht auf einem Substrat nach Anspruch 1, bei dem es sich bei mindestens einer auf der Oberfläche des Substrats abgeschiedenen Schicht um ein Siliciumoxid umfassendes Mischoxid handelt.

8. Verfahren zur Bildung mindestens einer siliciumoxidhaltigen Schicht auf einem Substrat nach Anspruch 7, bei dem das Mischoxid ein Oxid mit hohem Brechungsindex aus der Gruppe bestehend aus Zinnoxiden, Titanoxiden, Aluminiumoxiden, Zinkoxiden, Indiumoxiden und Mischungen davon umfasst.

9. Verfahren zur Bildung mindestens einer siliciumoxidhaltigen Schicht auf einem Substrat nach Anspruch 1, bei dem der verdampfte Vorläuferstrom ferner trockene Luft, Sauerstoff, Stickstoff und/oder Wasserdampf umfasst.

10. Verfahren zur Bildung mindestens einer siliciumoxidhaltigen Schicht auf einem Substrat nach Anspruch 1, bei dem der verdampfte Vorläuferstrom keinen Promotor enthält.

11. Verfahren zur Bildung mindestens einer siliciumoxidhaltigen Schicht auf einem Substrat nach Anspruch 1, bei dem das Monoalkylsilan nicht halogeniert ist.

12. Verfahren zur Bildung mindestens einer siliciumoxidhaltigen Schicht auf einem Substrat nach Anspruch 1, bei dem das Substrat auf eine Temperatur im Bereich von etwa 400 °C bis etwa 800 °C erhitzt wird.

13. Verfahren zur Bildung mindestens einer siliciumoxidhaltigen Schicht auf einem Substrat nach Anspruch 1, bei dem die mindestens eine Siliciumoxid umfassende Schicht mit einer Rate von mehr als etwa 3 nm/Sekunde auf der Oberfläche des Substrats abgeschieden wird.

14. Verfahren zur Bildung mindestens einer siliciumoxidhaltigen Schicht auf einem Substrat nach Anspruch 1, bei dem die Siliciumoxid umfassende Schicht mit einer Rate von mehr als etwa 5 nm/Sekunde auf der Oberfläche des Substrats abgeschieden wird.

## Revendications

1. Procédé de formation d'au moins une couche contenant de l'oxyde de silicium sur un substrat comprenant :
(a) le chauffage d'un substrat ;
(b) la vaporisation d'au moins un précurseur comprenant un monoalkylsilane choisi dans le groupe constitué par le n-butylsilane, le n-hexylsilane, le n-octylsilane et les mélanges de ceux-ci pour former un flux de précurseur vaporisé ; et
(c) la mise en contact d'une surface du substrat chauffé avec le flux de précurseur vaporisé à une pression proche de la pression atmosphérique, en présence d'un oxydant, afin de déposer au moins une couche comprenant de l'oxyde de silicium sur la surface du substrat.

2. Procédé de formation d'au moins une couche contenant de l'oxyde de silicium sur un substrat selon la revendication 1, dans lequel l'au moins une couche comprenant de l'oxyde de silicium a un indice de réfraction se situant dans la plage d'environ 1,4 jusqu'à environ 2,0.

3. Procédé de formation d'au moins une couche contenant de l'oxyde de silicium sur un substrat selon la revendication 1, dans lequel l'au moins une couche comprenant de l'oxyde de silicium est sensiblement transparente.

4. Procédé de formation d'au moins une couche contenant de l'oxyde de silicium sur un substrat selon la revendication 1, dans lequel le groupe alkyle du monoalkylsilane contient au moins quatre atomes de carbone.

5. Procédé de formation d'au moins une couche contenant de l'oxyde de silicium sur un substrat selon la revendication 1, dans lequel le substrat est choisi dans le groupe constitué par le verre, les résines fluoropolymères, les polyesters, les polyacrylates, les polyamides, les polyimides et les polycarbonates.

6. Procédé de formation d'au moins une couche contenant de l'oxyde de silicium sur un substrat selon la revendication 1, dans lequel au moins une couche déposée sur la surface du substrat est un oxyde de silicium sensiblement pur.

7. Procédé de formation d'au moins une couche contenant de l'oxyde de silicium sur un substrat selon la revendication 1, dans lequel au moins une couche déposée sur la surface du substrat est un oxyde mixte comprenant de l'oxyde de silicium.

8. Procédé de formation d'au moins une couche contenant de l'oxyde de silicium sur un substrat selon la revendication 7, dans lequel l'oxyde mixte comprend un oxyde présentant un indice de réfraction élevé choisi dans le groupe constitué par les oxydes d'étain, les oxydes de titane, les oxydes d'aluminium, les oxydes de zinc, les oxydes d'indium et les mélanges correspondants.

9. Procédé de formation d'au moins une couche contenant de l'oxyde de silicium sur un substrat selon la revendication 1, dans lequel le flux de précurseur vaporisé comprend en outre au moins l'un parmi l'air sec, l'oxygène, l'azote et la vapeur d'eau.

10. Procédé de formation d'au moins une couche contenant de l'oxyde de silicium sur un substrat selon la revendication 1, dans lequel le flux de précurseur vaporisé ne comporte pas de promoteur.

11. Procédé de formation d'au moins une couche contenant de l'oxyde de silicium sur un substrat selon la revendication 1, dans lequel le monoalkylsilane n'est pas halogéné.

12. Procédé de formation d'au moins une couche contenant de l'oxyde de silicium sur un substrat selon la revendication 1, dans lequel le substrat est chauffé à une température se situant dans la plage d'environ 400°C jusqu'à environ 800°C.

13. Procédé de formation d'au moins une couche contenant de l'oxyde de silicium sur un substrat selon la revendication 1, dans lequel l'au moins une couche comprenant de l'oxyde de silicium est déposée sur la surface du substrat à une vitesse supérieure à environ 3 nm/seconde.

14. Procédé de formation d'au moins une couche contenant de l'oxyde de silicium sur un substrat selon la revendication 1, dans lequel la couche comprenant de l'oxyde de silicium est déposée sur la surface du substrat à une vitesse supérieure à environ 5 nm/seconde.
